Europäisches Patentamt

European Patent Office

Office européen des brevets

(19)

(11) Veröffentlichungsnummer: **0 249 789**
**A1**

(12) **EUROPÄISCHE PATENTANMELDUNG**

(21) Anmeldenummer: 87107893.7

(22) Anmeldetag: 01.06.87

(51) Int. Cl.⁴: **H03K 19/21**

(30) Priorität: 10.06.86 DE 3619517

(43) Veröffentlichungstag der Anmeldung:
23.12.87 Patentblatt 87/52

(84) Benannte Vertragsstaaten:
AT DE FR GB NL

(71) Anmelder: **Siemens Aktiengesellschaft Berlin und München**
**Wittelsbacherplatz 2**
**D-8000 München 2(DE)**

(72) Erfinder: **Köppe, Siegmar, Dipl.-Ing.**
**Am Kamp 18**
**D-3014 Laatzen(DE)**

(54) **Antivalenz-und Äquivalenz-Gatterschaltungen.**

(57) Eine Antivalenz-Gatterschaltung in integrierter Schaltkreistechnik mit Feldeffekttransistoren bei der ein erster Signaleingang (1), dem ein erstes Eingangssignal (A) zuzuführen ist, unmittelbar mit dem Gate-Anschluß eines ersten Transfertransistors (11) und mittelbar, nämlich über einen ersten Inverter (17), mit dem Gate-Anschluß eines zweiten Transfertransistors (12) verbunden ist und ein zweiter Signaleingang (2), dem ein zweites Eingangssignal (B) zuzuführen ist, unmittelbar mit dem Source-Anschluß des zweiten Transfertransistors (12) und mittelbar, nämlich über einen zweiten Inverter (16), mit dem Source-Anschluß des ersten Transfertransistors (11) verbunden ist und bei der der Drain-Anschluß des ersten Transfertransistors (11) und der Drain-Anschluß des zweiten Transfertransistors (12) gemeinsam mit einem Signalausgang (3), über den ein Ausgangssignal (C) abzuführen ist, verbunden sind. Die Funktionen der beiden Inverter können fallweise durch solche ersetzt sein, die durch Inverter in der umgebenden Schaltung bereits gegeben sind.

**FIG 2**

## Antivalenz-und Äquivalenz-Gatterschaltungen

Die vorliegende Erfindung betrifft Antivalenz- und Äquivalenz-Gatterschaltungen in integrierter Schaltkreistechnik mit Feldeffekttransistoren.

Antivalenz-(Exklusiv-ODER, EXOR) und Äquivalenz-(EXNOR) Gatterschaltungen sind wesentliche Bestandteile vieler integrierter Digitalschaltungen. Sie werden z. B. in Addierern, Vergleichern und übergeordneten Strukturen, wie Multiplizierern, digitalen Filtern usw. verwendet.

Schaltungsanordnungen zum Realisieren der Antivalenz-bzw. Äquivalenzfunktion sind bekannt. Sie sind im allgemeinen aus Teilschaltungsanordnungen zur Realisierung der beiden logischen Grundfunktionen "NAND" und "NOR" (und deren Mischformen "ANDNOR" und "ORNAND") zusammengesetzt. Die Anzahl der erforderlichen Transistoren ist entsprechend hoch. Ein hoher Transistoraufwand bedingt einen großen Flächenbedarf und wirkt sich nachteilig auf die Eigenschaften der Schaltungsanordnung, beispielsweise auf die Laufzeit, aus.

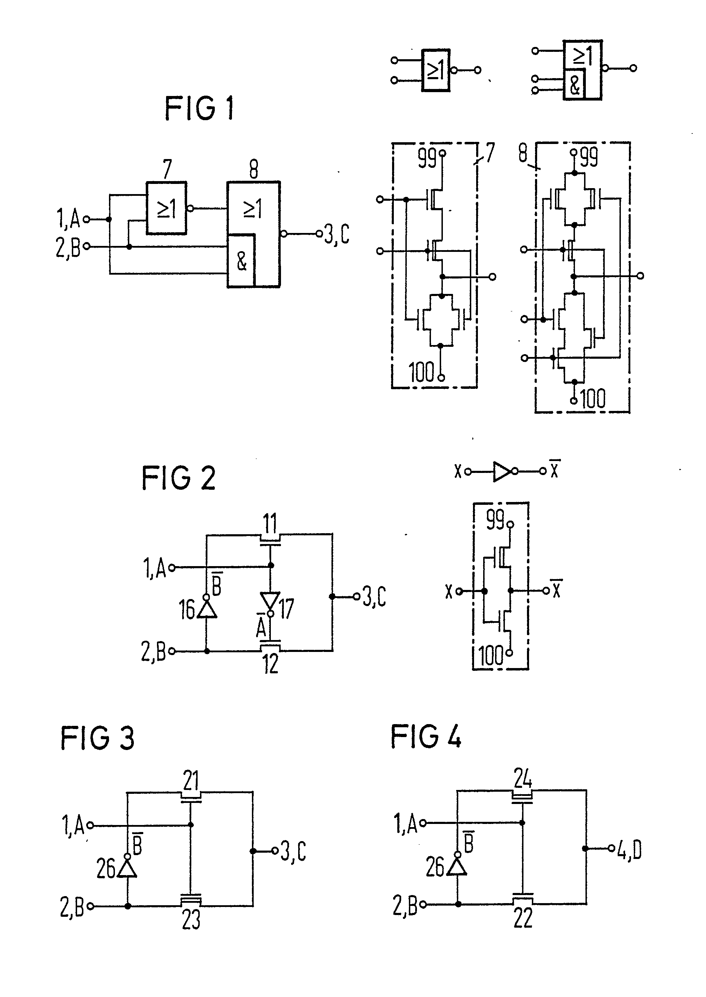

In Fig. 1 ist beispielhaft die mögliche Realisierung der Antivalenzfunktion (EXOR) in statischer CMOS-Technik gezeigt. Diese Schaltungsanordnung enthält zehn Transistoren.

Der vorliegenden Erfindung liegt die Aufgabe zugrunde, Schaltungsanordnungen der eingangs genannten Art zu schaffen, bei denen der Aufwand an Transistoren wesentlich verringert ist.

Zur Lösung dieser Aufgabe werden verschiedene Antivalenz-bzw. Äquivalenz-Gatterschaltungen gemäß den Oberbegriffen mehrerer voneinander unabhängiger Patentansprüche vorgeschlagen, welche Gatterschaltungen jeweils durch die in den kennzeichnenden Teilen dieser Patentansprüche angegebenen Merkmale charakterisiert sind.

Vorteilhafte Weiterbildungen der vorliegenden Erfindung sind durch die Merkmale der Unteransprüche gekennzeichnet.

Im folgenden wird die Erfindung anhand mehrerer Figuren im einzelnen erläutert.

Fig. 1 zeigt ein Ausführungsbeispiel für eine Antivalenz-Gatterschaltung im CMOS-Technik gemäß einer bekannten Gatterschaltungskonzeption.

Fig. 2 zeigt eine erste erfindungsgemäße Ausführungsform einer Antivalenz-Gatterschaltung.

Fig. 3 zeigt eine zweite erfindungsgemäße Ausführungsform einer Antivalenz-Gatterschaltung.

Fig. 4 zeigt eine erste erfindungsgemäße Ausführungsform einer Äquivalenz-Gatterschaltung.

Fig. 5 zeigt eine dritte erfindungsgemäße Ausführungsform einer Antivalenz-Gatterschaltung.

Fig. 6 zeigt eine zweite erfindungsgemäße Ausführungsform einer Äquivalenz-Gatterschaltung.

Fig. 7 zeigt eine Schaltungsanordnung eines Ausführungsbeispiels für eine sog. statische Registerzelle, die vorteilhaft mit einer bestimmten erfindungsgemäßen Ausführungsform einer Gatterschaltung zusammenarbeiten kann.

Fig. 8 zeigt eine Schaltungsanordnung eines Ausführungsbeispiels für ein erfindungsgemäßes Antivalenzgatter mit einer vorgeschalteten Registerzelle gemäß Fig. 7.

Fig. 9 zeigt eine Schaltungsanordnung einer kaskadenartigen Antivalenz-Gatterschaltung.

Fig.10 zeigt eine für bestimmte Anwendungsfälle verbesserte Ausführungsform der Schaltungsanordnung gemäß Fig. 9.

Wie bereits erläutert, zeigt Fig. 2 eine erste Ausführungsform einer erfindungsgemäßen Antivalenz-Gatterschaltung, die in integrierter Schaltkreistechnik mit Feldeffekttransistoren ausgeführt ist. Ein erster Signaleingang (1), dem ein erstes Eingangssignal (A) zuzuführen ist, ist unmittelbar mit dem Gate-Anschluß eines ersten Transfertransistors (11) und mittelbar, nämlich über einen ersten Inverter (17), mit dem Gate-Anschluß eines zweiten Transfertransistors (12) verbunden. Ein zweiter Signaleingang (2), dem ein zweites Eingangssignal (B) zuzuführen ist, ist unmittelbar mit dem Source-Anschluß des zweiten Transfertransistors (12) und mittelbar, nämlich über einen zweiten Inverter (16), mit dem Source-Anschluß des ersten Transfertransistors (11) verbunden. Der Drain-Anschluß des ersten Transfertransistors (11) und der Drain-Anschluß des zweiten Transfertransistors (12) sind gemeinsam mit einem Signalausgang (3), über den ein Ausgangssignal (C) abzuführen ist, verbunden. In dem gezeigten Ausführungsbeispiel sind die Transfertransistoren als n-Kanal-Feldeffekttransistoren ausgeführt.

Für A = 1 ist der Transfertransistor 11 leitend und der Transfertransistor 12 sperrt. An den Ausgang C gelangt das durch den Inverter 16 invertierte Eingangssignal $\overline{B}$ . Entsprechend ist für A = 0 der Transfertransistor 12 (über den Inverter 17 mit dem Signal $\overline{A}$ angesteuert) leitend und führt dem Ausgang C das Eingangssignal B zu. Der Transfertransistor 11 sperrt in diesem Zustand. Für die in Fig. 2 dargestellte beispielhafte Realisierung der Antivalenzfunktion in CMOS-Technik werden 6 Transistoren benötigt. Gleiches gilt für die komplementäre Äquivalenzfunktion, die beispielsweise durch Verwendung komplementärer Transfertransistoren zu realisieren ist.

Eine Verringerung der Anzahl der Transfertransistoren läßt sich auf einfache Weise erzielen, indem der n-Kanal-Transfertransistor 12 mitsamt dem Inverter 17 durch einen p-Kanal-Transfertransistor ersetzt wird, vergl. Fig. 3. Die Transistorzahl sinkt damit auf 4. Die Äquivalenzfunktion (EXNOR) ergibt sich durch Austausch der beiden Transfertransistoren 21 und 23 gegen ihr jeweiliges Komplement, vergl. Fig. 4.

Im einzelnen ist für ein Ausführungsbeispiel einer Antivalenz-Gatterschaltung in Fig. 3 gezeigt, daß ein erster Signaleingang (1), dem ein erstes Eingangssignal (A) zuzuführen ist, mit dem Gate-Anschluß eines n-Kanal-Transfertransistors (21) und mit dem Gate-Anschluß eines p-Kanal-Transfertransistors (23) verbunden ist und ein zweiter Signaleingang (2), dem ein zweites Eingangssignal (B) zuzuführen ist, unmittelbar mit dem Source-Anschluß des p-Kanal-Transfertransistors (23) und mittelbar, nämlich über einen Inverter (26), mit dem Source-Anschluß des n-Kanal-Transfertransistors (21) verbunden ist und daß der Drain-Anschluß des n-Kanal-Transfertransistors (21) und der Drain-Anschluß des p-Kanal-Transfertransistors (23) gemeinsam mit einem Signalausgang (3), über den ein Ausgangssignal (C) abzuführen ist, verbunden sind.

Ebenso ist im einzelnen für ein Ausführungsbeispiel einer Äquivalenz-Gatterschaltung in Fig. 4 gezeigt, daß ein erster Signaleingang (1), dem ein erstes Eingangssignal (A) zuzuführen ist, mit dem Gate-Anschluß eines p-Kanal-Transfertransistors (24) und mit dem Gate-Anschluß eines n-Kanal-Transfertransistors (22) verbunden ist und ein zweiter Signaleingang (2), dem ein zweites Eingangssignal (B) zuzuführen ist, unmittelbar mit dem Source-Anschluß des n-Kanal-Transfertransistors (22) und mittelbar, nämlich über einen Inverter (26), mit dem Source-Anschluß des p-Kanal-Transfertransistors (24) verbunden ist und daß der Drain-Anschluß des n-Kanal-Transfertransistors (22) und der Drain-Anschluß des p-Kanal-Transfertransistors (24) gemeinsam mit einem Signalausgang (4), über den ein Ausgangssignal (D) abzuführen ist, verbunden sind.

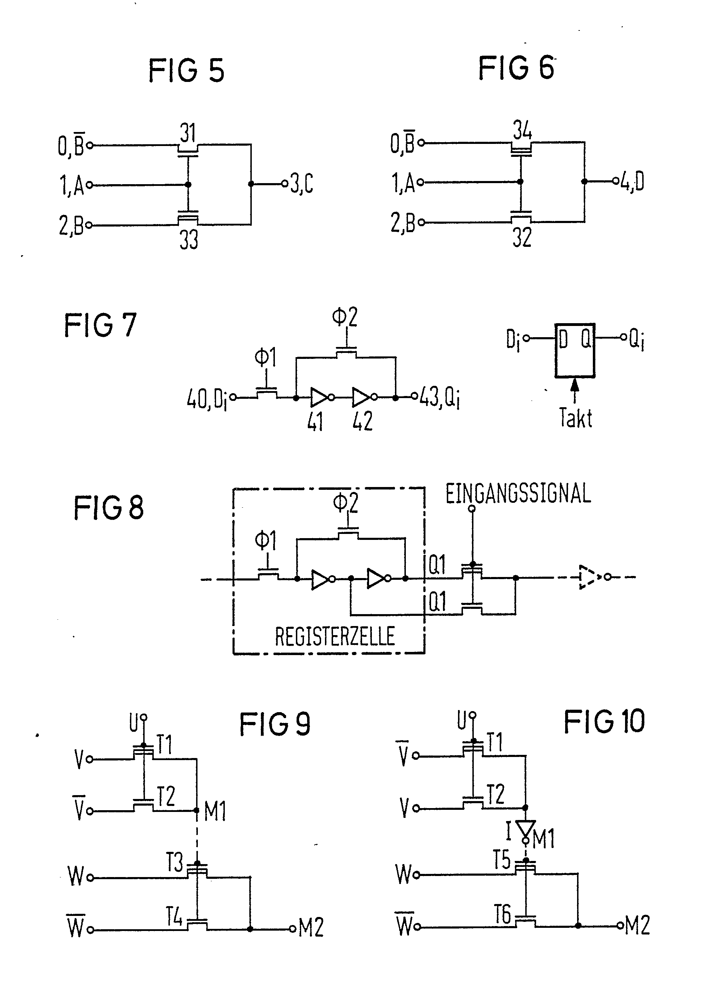

Eine weitere Verringerung der Transistoranzahl für jede der beiden Funktionen läßt sich in allen Strukturen erzielen, in denen das Eingangssignal B sowohl in invertierter als auch in nicht-invertierter Form ( $\overline{B}$ und B) verfügbar ist. In diesen Fällen muß die Erzeugung des Signals $\overline{B}$ nicht mehr innerhalb des Gatters erfolgen, und der Inverter 26 in Fig. 3 und Fig. 4 kann entfallen. Zur Realisierung der Antivalenz-bzw. Äquivalenzfunktion sind dann nur noch jeweils 2 Transistoren notwendig, vergl. Fig. 5 und Fig. 6.

Im einzelnen ist in Fig. 5 gezeigt, daß ein erster Signaleingang (1), dem ein erstes Eingangssignal (A) zuzuführen ist, mit dem Gate-Anschluß eines n-Kanal-Transfertransistors (31) und mit dem Gate-Anschluß eines p-Kanal-Transfertransistors (33) verbunden ist, ein zweiter Signaleingang (2), dem ein zweites Eingangssignal (B) zuzuführen ist, mit dem Source-Anschluß des p-Kanal-Transfertransistors (33) und ein dritter Signaleingang (O), dem das invertierte zweite Eingangssignal ( $\overline{B}$ ) zuzuführen ist, mit dem Source-Anschluß des n-Kanal-Transfertransistors (31) verbunden ist und daß der Drain-Anschluß des n-Kanal-Transfertransistors (31) und der Drain-Anschluß des p-Kanal-Transfertransistors (33) gemeinsam mit einem Signalausgang (3), über den ein Ausgangssignal (C) abzuführen ist, verbunden sind.

Ebenso ist im einzelnen in Fig. 6 gezeigt, daß ein erster Signaleingang (1), dem ein erstes Eingangssignal (A) zuzuführen ist, mit dem Gate-Anschluß eines n-Kanal-Transfertransistors (32) und mit dem Gate-Anschluß eines p-Kanal-Transfertransistors (34) verbunden ist, ein zweiter Signaleingang (2), dem ein zweites Eingangssignal (B) zuzuführen ist, mit dem Source-Anschluß des n-Kanal-Transfertransistors (32) und ein dritter Signaleingang (O), dem das invertierte zweite Eingangssignal ( $\overline{B}$ ) zuzuführen ist, mit dem Source-Anschluß des p-Kanal-Transfertransistors (34) verbunden ist und daß der Drain-Anschluß des n-Kanal-Transfertransistors (32) und der Drain-Anschluß des p-Kanal-Transfertransistors (34) gemeinsam mit einem Signalausgang (4), über den ein Ausgangssignal (D) abzuführen ist, verbunden sind.

Die Voraussetzung für eine derartige weitere Verringerung der Transistorzahl ist beispielsweise dann erfüllt, wenn mindestens eines der beiden zu verknüpfenden Signale von einer Registerzelle geliefert wird. Zur Erläuterung sei willkürlich eine statische Registerzelle betrachtet, vergl. Fig. 7, welche durch nichtüberlappenden Takte Ø1 und Ø2 gesteuert wird. (Anmerkung: Die Art der Registerzellen hat keinen Einfluß auf die erfindungsgemäße Realisierung; es genügt, daß Registerzellen generell Inverter enthalten.)

Wie Fig. 8 zeigt, wird einer der beiden Inverter der Registerzelle zur Aufwandsverringerung des EXOR-Gatters genutzt. Die dem EXOR-Gatter nachgeschaltete Stufe (in der Figur durch einen Inverter repräsentiert) sorgt für eine Auffrischung des Signalpegels.

Antivalenz-und Äquivalenzschaltungen zur Verknüpfung von mehr als zwei Signalen lassen sich durch Kaskaden realisieren. Die Reihenfolge der Verknüpfung ist dabei beliebig (assoziative Funktionen). Eine erfindungsgemäße Realisierung sei beispielhaft für ein EXOR-Gatter mit drei Eingängen erläutert, vergl. Fig. 9.

Im einzelnen zeigt Fig. 9 eine kaskadenartige Antivalenz-Gatterschaltung für drei Eingangsvariablen. Ein erster Signaleingang (U), dem ein erstes Eingangssignal zuzuführen ist, ist mit dem Gate-Anschluß eines ersten p-Kanal-Transfertransistors (T1) und dem Gate-Anschluß eines ersten n-Kanal-Transfertransistors (T2) verbunden. Ein zweiter Signaleingang (V), dem ein zweites Eingangssignal zuzuführen ist, ist mit dem Source-Anschluß des ersten p-Kanal-Transfertransistors (T1) und ein dem zweiten Signaleingang (V) zugeordneter Hilfseingang ($\overline{V}$), dem das invertierte zweite Eingangssignal zuzuführen ist, mit dem Source-Anschluß des ersten n-Kanal-Transfertransistors (T2) verbunden. Der Drain-Anschluß des ersten p-Kanal-Transfertransistors (T1) und der Drain-Anschluß des ersten n-Kanal-Transfertransistors (T2) sind gemeinsam mit dem Gate-Anschluß eines zweiten p-Kanal-Transfertransistors (T3) und dem Gate-Anschluß eines zweiten n-Kanal-Transfertransistors (T4) verbunden. Ein dritter Signaleingang (W), dem ein drittes Eingangssignal zuzuführen ist, ist mit dem Source-Anschluß des zweiten p-Kanal-Transfertransistors (T3) und ein dem dritten Signaleingang (W) zugeordneter Hilfseingang ($\overline{W}$), dem das invertierte dritte Eingangssignal zuzuführen ist, mit dem Source-Anschluß des zweiten n-Kanal-Transfertransistors (T4) verbunden. Der Drain-Anschluß des zweiten p-Kanal-Transfertransistors (T3) und der Drain-Anschluß des zweiten n-Kanal-Transfertransistors (T4) sind gemeinsam mit einem Signalausgang (M2), über den ein Ausgangssignal abzuführen ist, verbunden.

Fig. 10 zeigt, wie bereits erläutert, eine für bestimmte Anwendungsfälle verbesserte Ausführungsform einer kaskadenartigen Antivalenzgatterschaltung für drei Eingangsvariablen. Ein erster Signaleingang (U), dem ein erstes Eingangssignal zuzuführen ist, ist mit dem Gate-Anschluß eines ersten p-Kanal-Transfertransistors (T1) und dem Gate-Anschluß eines ersten n-Kanal-Transfertransistors (T2) verbunden. Ein zweiter Signaleingang ($\overline{V}$), dem ein zweites Eingangssignal zuzuführen ist, ist mit dem Source-Anschluß des ersten n-Kanal-Transfertransistors (T2) und ein dem zweiten Signaleingang (V) zugeordneter Hilfseingang ($\overline{V}$), dem das invertierte zweite Eingangssignal zuzuführen ist, mit dem Source-Anschluß des ersten p-Kanal-Transfertransistors (T1) verbunden. Der Drain-Anschluß des ersten p-Kanal-Transfertransistors (T1) und der Drain-Anschluß des ersten n-Kanal-Transfertransistors (T2) sind gemeinsam über einen Inverter (I), dessen Signalausgang einen Signalausgang M1 bildet, mit dem Gate-Anschluß eines zweiten p-Kanal-Transfertransistors (T5) und dem Gate-Anschluß eines zweiten n-Kanal-Transfertransistors (T6) verbunden. Ein dritter Signaleingang (W), dem ein drittes Eingangssignal zuzuführen ist, ist mit dem Source-Anschluß des zweiten p-Kanal-Transfertransistors (T5) und ein dem dritten Signaleingang (W) zugeordneter Hilfseingang ($\overline{W}$), dem das invertierte dritte Eingangssignal zuzuführen ist, mit dem Source-Anschluß des zweiten n-Kanal-Transfertransistors (T6) verbunden. Der Drain-Anschluß des zweiten p-Kanal-Transfertransistors (T5) und der Drain-Anschluß des zweiten n-Kanal-Transfertransistors (T6) sind gemeinsam mit einem Signalausgang (M2), der den Signalausgang der gesamten Gatterschaltung bildet und über den ein Ausgangssignal abzuführen ist, verbunden.

Der eingefügte Inverter bietet den Vorteil einer Signalauffrischung.

Eine derartige kaskadenartige Gatterschaltung kann in bestimmtem Maße für eine Vielzahl von Eingangsvariablen ausgebildet werden. In einer solchen kaskadenartigen Gatterschaltung für n Eingangsvariablen ist erfindungsgemäß vorgesehen, daß n-1 Transfertransistorpaare ($T_1/T_2$, $T_3/T_4$; $T_1/T_2$, $T_5/T_6$) vorgesehen sind, wobei die Transfertransistorpaare jeweils einen p-Kanal-Transfertransistor ($T_1$, $T_3$; $T_1$, $T_5$) und einen n-Kanal-Transfertransistor ($T_2$, $T_4$; $T_2$, $T_6$) enthalten, daß ein erster Signaleingang (U), dem ein erstes Eingangssignal als die erste Eingangsvariable der n Eingangsvariablen zuzuführen ist, mit den Gate-Anschlüssen der Transfertransistoren eines ersten Transfertransistorpaares ($T_1/T_2$) verbunden ist, daß die Source-Anschlüsse der Transfertransistoren des ersten Transfertransistorpaares ($T_1/T_2$) mit einem zweiten Signaleingang (V) bzw. einem diesem zugeordneten Hilfseingang ($\overline{V}$) verbunden sind, denen ein zweites Eingangssignal als zweite Eingangsvariable der n Eingangsvariablen bzw. das invertierte zweite Eingangssignal zuzuführen ist, daß die Source-Anschlüsse der Transfertransistoren eines zweiten Transfertransistorpaares mit einem dritten Signaleingang bzw. einem diesem zu geordneten Hilfseingang verbunden sind, denen ein drittes Eingangssignal als dritte Eingangsvariable der n Eingangsvariablen bzw. das invertierte dritte Eingangssignal zuzuführen ist, usw., daß die Source-Anschlüsse der Transfertransistoren eines (n-1)-ten Transfertransistorpaares mit einem n-ten Signaleingang (W) bzw. einem diesem zugeordneten Hilfseingang ($\overline{W}$) verbunden sind, denen ein n-tes Eingangssignal als n-te Eingangsvariable bzw. das invertierte n-te Eingangssignal zuzuführen ist, daß die Drain-Anschlüsse der Transfertransistoren der n-2 Transfertransistorpaare jeweils einen Signalausgang ($M_1$) bilden, der mit den Gate-Anschlüssen der Transfertransistoren des jeweils nachgeordneten Transfertransistorpaares ($T_3/T_4$; $T_5/T_6$) verbunden ist, und daß der Signalausgang ($M_2$) des (n-1)-

ten Transfertransistorpaares den Signalausgang der Gatterschaltung bildet. Vorzugsweise ist n = 3, d. h. es wird eine kaskadenartige Gatterschaltung für drei Eingangsvariablen gebildet.

Erfindungsgemäß ist vorgesehen, daß die Zuordnung des p-Kanal-und des n-Kanal-Transfertransistors zu dem betreffenden Signaleingang bzw. dem diesem zugeordneten Hilfseingang jeweils derart ist, daß die Gatterschaltung eine Antivalenzgatterfunktion erfüllt.

Dementsprechend ist außerdem erfindungsgemäß vorgesehen, daß die Zuordnung des p-Kanal-und des n-Kanal-Transfertransistors zu dem betreffenden Signaleingang bzw. dem diesem zugeordneten Hilfseingang jeweils derart ist, daß die Gatterschaltung eine Äquivalenzgatterfunktion erfüllt.

Eine vorteilhafte Weiterbildung der Erfindung sieht vor, daß jeweils zwischen den Drain-Anschlüssen der Transistoren eines Transfertransistorpaares und dem jeweils zugeordneten Signalausgang $(M_1)$ ein Inverter eingefügt ist.

Stehen mindestens zwei der zu verknüpfenden Signale auch in invertierter Form zur Verfügung (hier die Signale V und W), läßt sich die geforderte Funktion

$$M2 = U \oplus V \oplus W$$

durch zwei Multiplexer mit zusammen vier Transistoren realisieren. Dazu wird zunächst das Zwischensignal M1 als Antivalenz der Eingangssignale U und V gebildet (M1 = U $\oplus$ V). Dieses steuert wiederum einen zweiten Multiplexer, an dessen Eingängen W und $\overline{W}$ anliegen. Am Ausgang dieses Multiplexers ergibt sich damit das gewünschte Signal

$$M2 = M1 \oplus W = U \oplus V \oplus W.$$

Vorzugsweise werden die Transfertransistoren in CMOS-Technik ausgeführt.

## Ansprüche

1. Antivalenz-Gatterschaltung in integrierter Schaltkreistechnik mit Feldeffekttransistoren, dadurch **gekennzeichnet,**
-daß ein erster Signaleingang (1), dem ein erstes Eingangssignal (A) zuzuführen ist, unmittelbar mit dem Gate-Anschluß eines ersten Transfertransistors (11) und mittelbar, nämlich über einen ersten Inverter (17), mit dem Gate-Anschluß eines zweiten Transfertransistors (12) verbunden ist und ein zweiter Signaleingang (2), dem ein zweites Eingangssignal (B) zuzuführen ist, unmittelbar mit dem Source-Anschluß des zweiten Transfertransistors (12) und mittelbar, nämlich über einen zweiten Inverter (16), mit dem Source-Anschluß des ersten Transfertransistors (11) verbunden ist und
-daß der Drain-Anschluß des ersten Transfertransistors (11) und der Drain-Anschluß des zweiten Transfertransistors (12) gemeinsam mit einem Signalausgang (3), über den ein Ausgangssignal (C) abzuführen ist, verbunden sind.

2. Antivalenz-Gatterschaltung nach Anspruch 1, dadurch **gekennzeichnet,** daß die Transfertransistoren (11, 12) n-Kanal-Feldeffekttransistoren sind.

3. Antivalenz-Gatterschaltung in integrierter Schaltkreistechnik mit Feldeffekttransistoren, dadurch **gekennzeichnet,**
-daß ein erster Signaleingang (1), dem ein erstes Eingangssignal (A) zuzuführen ist, mit dem Gate-Anschluß eines n-Kanal-Transfertransistors (21) und mit dem Gate-Anschluß eines p-Kanal-Transfertransistors (23) verbunden ist und ein zweiter Signaleingang (2), dem ein zweites Eingangssignal (B) zuzuführen ist, unmittelbar mit dem Source-Anschluß des p-Kanal-Transfertransistors (23) und mittelbar, nämlich über einen Inverter (26), mit dem Source-Anschluß des n-Kanal-Transfertransistors (21) verbunden ist und
-daß der Drain-Anschluß des n-Kanal-Transfertransistors (21) und der Drain-Anschluß des p-Kanal-Transfertransistors (23) gemeinsam mit einem Signalausgang (3), über den ein Ausgangssignal (C) abzuführen ist, verbunden sind.

4. Äquivalenz-Gatterschaltung in intergrierter Schaltkreistechnik mit Feldeffekttransistoren, dadurch **gekennzeichnet,**
-daß ein erster Signaleingang (1), dem ein erstes Eingangssignal (A) zuzuführen ist, mit dem Gate-Anschluß eines p-kanal-Transfertransistors (24) und mit dem Gate-Anschluß eines n-Kanal-Transfertransistors (22) verbunden ist und ein zweiter Signaleingang (2), dem ein zweites Eingangssignal (B) zuzuführen ist, unmittelbar mit dem Source-Anschluß des n-Kanal-Transfertransistors (22) und mittelbar, nämlich über einen Inverter (26), mit dem Source-Anschluß des p-Kanal-Transfertransistors (24) verbunden ist und
-daß der Drain-Anschluß des n-kanal-Transfertransistors (22) und der Drain-Anschluß des p-Kanal-Transfertransistors (24) gemeinsam mit einem Signalausgang (4), über den ein Ausgangssignal (D) abzuführen ist, verbunden sind.

5. Antivalenz-Gatterschaltung in intgrierter Schaltkreistechnik mit Feldeffekttransistoren, dadurch **gekennzeichnet,**
-daß ein erster Signaleingang (1), dem ein erstes Einganmgssignal (A) zuzuführen ist, mit dem Gate-Anschluß eines n-kanal-Transfertransistors (31) und mit dem Gate-Anschluß eines p-Kanal-Transfertransistors (33) verbunden ist, ein zweiter Signaleingang (2), dem ein zweites Eingangssignal (B) zuzuführen ist, mit dem Source-Anschluß des p-Kanal-Transfertransistors (33) und ein dritter Signaleingang (O), dem das invertierte zweite Eingangssignal ($\overline{B}$) zuzuführen ist, mit dem Source-Anschluß des n-Kanal-Transfertransistors (31) verbundne ist und

-daß der Drain-Anschluß des n-Kanal-Transfertransistors (31) und der Drain-Anschluß des p-Kanal-Transfertransistors (33) gemeinsam mit einem Signalausgang (3), über den ein Ausgangssignal (C) abzuführen ist, verbunden sind.

6. Äquivalenz-Gatterschaltung in integrierter Schaltkreistechnik mit Feldeffekttransistoren, dadurch **gekennzeichnet**

-daß ein erster Signaleingang (1), dem ein erstes Eingangssignal (A) zuzuführen ist, mit dem Gate-Anschluß eines n-Kanal-Transfertransistors (32) und mit dem Gate-Anschluß eines p-Kanal-Transfertransistors (34) verbunden ist, ein zweiter Signaleingang (2), dem ein zweites Eingangssignal (B) zuzuführen ist, mit dem Source-Anschluß des n-Kanal-Transfertransistors (32) und ein dritter Signaleingang (O), dem das invertierte zweite Eingangssignal ($\overline{B}$) zuzuführen ist, mit dem Source-Anschluß des p-Kanal-Transfertransistors (34) verbunden ist und

-daß der Drain-Anschluß des n-kanal-Transfertransistors (32) und der Drain-Anschluß des p-Kanal-transfertransistors (34) gemeinsam mit einem Signalausgang (4), über den ein Ausgangssignal (D) abzuführen ist, verbunden sind.

7. Kaskadenartige Gatterschaltung für n Eingangsvariablen in integrierter Schaltkreistechnik mit Feldeffekttransistoren, dadurch **gekennzeichnet**, -daß n-1 Transfertransistorpaare ($T_1/T_2$, $T_3/T_4$; $T_1/T_2$, $T_5/T_6$) vorgesehen sind, wobei die Transfertransistorpaare jeweils einen p-kanal-Transfertransistor ($T_1$, $T_3$; $T_1$, $T_5$) und einen n-kanal-Transfertransistor ($T_2$, $T_4$; $T_2$, $T_6$) enthalten,

-daß ein erster Signaleingang (U), dem ein erstes Eingangssignal als die erste Eingangsvariable der n Eingangsvariablen zuzuführen ist, mit den Gate-Anschlüssen der Transfertransistoren eines ersten Transfertransistorpaares ($T_1/T_2$) verbunden ist,

-daß die Source-Anschlüsse der Transfertransistoren des ersten Transfertransistorpaares ($T_1/T_2$) mit einem zweiten Signaleingang (V) ozw. einem diesem zugeordneten Hilfseingang ($\overline{V}$) verbunden sind, denen ein zweites Eingangssignal als zweite Eingangsvariable der n Eingangsvariablen bzw. das invertierte zweite Eingangssignal zuzuführen ist,

-daß die Source-Anschlüsse der Transfertransistoren eines zweiten aTransfertransistorpaares mit einem dritten Signaleingang bzw. einem diesem zugeordneten Hilfseingang verbunden sind, denen ein drittes Eingangssignal als dritte Eingangsvariable der n Eingangsvariablen bzw. das invertierte dritte Eingangssignal zuzuführen ist, usw.,

-daß die Source-Anschlüsse der Transfertransistoren eines (n-1)-ten Transfertransistorpaares mit einem n-ten Signaleingang (W) bzw. einem diesem zugeordneten Hilfseingang ($\overline{W}$) verbunden sind, denen ein n-tes Eingangssignal als n-te Eingangsvariable bzw. das invertierte n-te Eingangssignal zuzuführen ist,

-daß die Drain Anschlüsse der Transfertransistoren der n-2 Transfertransistorpaare jeweils einen Signalausgang ($M_1$) bilden, der mit den Gate-Anschlüssen der Transfertransistoren des jeweils nachgeordneten Transfertransistorpaares ($T_3/T_4$; $T_5/T_6$) verbunden ist, und

-daß der Signalausgang ($M_2$) der (n-1)-ten Transfertransistorpaares den Signalausgang der Gatterschaltung bildet.

8. Kaskadenartige Gatterschaltung nach Anspruch 7, dadurch **gekennzeichnet**, daß n = 3 ist.

9. Kaskadenartige Gatterschaltung nach Anspruch 7 oder 8, dadurch **gekennzeichnet**, daß die Zuordnung des p-Kanal-und des n-kanal-Transfertransistors zu dem betreffenden Signaleingang bzw. dem diesem zugeordneten Hilfseingang jeweils derart ist, daß die Gatterschaltung eine Antivalenzgatterfunktion erfüllt.

10. Kaskadenartige Gatterschaltung nach Anspruch 7 oder 8, dadurch **gekennzeichnet**, daß die Zuordnung des p-Kanal-und des n-Kanal-Transfertransistors zu dem betreffenden Signaleingang bzw. dem diesem zugeordneten Hilfseingang jeweils derart ist, daß die Gaterschaltung eine Äquivalenzgatterfunktion erfüllt.

11. Kaskadenartige Gatterschalung nach einem der Ansprüche 7 - 10, dadurch **gekennzeichnet**, daß jeweils zwischen den Drain-Anschlüssen der Transistoren eines Transfertransistorpaares und dem jeweils zugeordneten Signalausgang ($M_1$) ein Inverter eingefügt ist.

12. Gatterschaltung nach einem der vorhergehenden Ansprüche, dadurch **gekennzeichnet**, daß die Transfertransistoren in CMOS-Technik ausgeführt sind.

0 249 789

FIG 1

FIG 2

FIG 3

FIG 4

# FIG 5

0,$\overline{B}$  o—━━[ 31 ]
1,A  o————————•———————•—o 3,C
2,B  o—━━[ 33 ]

# FIG 6

0,$\overline{B}$  o—━━[ 34 ]
1,A  o————————•———————•—o 4,D
2,B  o—━━[ 32 ]

# FIG 7

$\Phi 2$

$\Phi 1$

40,$D_i$ o—━━•—▷o—▷o—•—o 43,$Q_i$
        41   42

$D_i$ o—[ D  Q ]—o $Q_i$

Takt

# FIG 8

$\Phi 2$

$\Phi 1$

EINGANGSSIGNAL

Q1

Q1

REGISTERZELLE

# FIG 9

U o
V o—━━[ T1 ]
$\overline{V}$ o—━━[ T2 ]  • M1

W o—━━[ T3 ]
$\overline{W}$ o—━━[ T4 ]  •—o M2

# FIG 10

U o
$\overline{V}$ o—━━[ T1 ]
V o—━━[ T2 ]

I ▽ M1

W o—━━[ T5 ]
$\overline{W}$ o—━━[ T6 ]  •—o M2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | PATENT ABSTRACTS OF JAPAN, Band 10, Nr. 236 (E-428)[2292], 15. August 1986; & JP-A-61 69 216 (NEC CORP.) 09-04-1986 * Zusammenfassung; Figur * | 1,2 | H 03 K 19/21 |
| X | FR-A-2 516 675 (LABORATOIRE CENTRAL DE TELECOMMUNICATIONS SA) * Figur 9; Seite 6, Zeilen 10-19 * | 1,2 | |
| X | IBM TECHNICAL DISCLOSURE BULLETIN, Band 25, Nr. 5, Oktober 1982, Seiten 2375-2376, New York, US; Z.T. DEARDEN et al.: "Four-device exclusive or CMOS circuit" * Figuren; Seiten 2375-2376 * | 3,5 | RECHERCHIERTE SACHGEBIETE (Int. Cl.4) |
| Y | Idem | 4,6,7, 9,10 | H 03 K |
| Y | PROCEEDINGS OF THE IEEE, Band 73, Nr. 4, April 1985, Seiten 592-598, IEEE, New York, US; P. PIRSCH: "Design of a DPCM codec for VLSI realization in CMOS technology" * Figur 6 * | 4,6,10 | |

-/-

Der vorliegende Recherchenbericht wurde für alle Patentansprüche erstellt.

| Recherchenort | Abschlußdatum der Recherche | Prüfer |
|---|---|---|
| DEN HAAG | 04-09-1987 | FEUER F.S. |

KATEGORIE DER GENANNTEN DOKUMENTE
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82

# EUROPÄISCHER RECHERCHENBERICHT

Europäisches
Patentamt

Nummer der Anmeldung

EP 87 10 7893

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | FR-A-2 296 969 (COMPAGNIE IBM FRANCE)<br>* Figur 1, Seite 2, Zeile 36 - Seite 3, Zeile 25 * | 7,9,10 | |

-----

RECHERCHIERTE
SACHGEBIETE (Int. Cl.4)

Der vorliegende Recherchenbericht wurde für alle Patentansprüche erstellt.

| Recherchenort | Abschlußdatum der Recherche | Prüfer |
|---|---|---|
| DEN HAAG | 04-09-1987 | FEUER F.S. |

KATEGORIE DER GENANNTEN DOKUMENTE
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82